(19) 

Europäisches
Patentamt

European
Patent Office

Office européen
des brevets

(11) **EP 4 757 175 A1**

(12) **DEMANDE DE BREVET EUROPEEN**

(43) Date de publication:
**10.06.2026 Bulletin 2026/24**

(21) Numéro de dépôt: **25315230.0**

(22) Date de dépôt: **27.06.2025**

(51) Classification Internationale des Brevets (IPC):
**H03F 3/195** (2006.01)   **H03F 3/24** (2006.01)
**H03F 3/45** (2006.01)   **H03G 1/00** (2006.01)

(52) Classification Coopérative des Brevets (CPC):
**H03F 3/45089; H03F 3/195; H03F 3/245;**
**H03G 1/0088;** H03F 2203/45024;
H03F 2203/45031; H03F 2203/45032;
H03F 2203/45052; H03F 2203/45056;
H03F 2203/45331; H03F 2203/45641;
H03F 2203/45711; H03F 2203/45726

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**
Etats d'extension désignés:
**BA**
Etats de validation désignés:
**GE KH LA MA MD TN**

(30) Priorité: **09.12.2024 EP 24315561**

(71) Demandeur: **STMicroelectronics International
N.V.**
**1228 Plan-les-Ouates, Geneva (CH)**

(72) Inventeurs:
• **Gomes, Leonardo**
  **38000 GRENOBLE (FR)**
• **Paillardet, Frederic**
  **73100 TRESSERVE (FR)**

(74) Mandataire: **Cabinet Beaumont**
**4, Place Robert Schuman**
**B.P. 1529**
**38025 Grenoble Cedex 1 (FR)**

(54) **DISPOSITIF ET PROCÉDÉ D'AMPLIFICATION À GAIN VARIABLE**

(57)   La présente description concerne un dispositif d'amplification à gain variable (1) et un procédé d'amplification à gain variable, dans lesquels une segmentation d'une commutation en courant (102) est mise en œuvre en au moins deux parties (1021, 1022).

Fig 1

**Description**

<u>Domaine technique</u>

La présente description concerne de façon générale les circuits électroniques, et plus particulièrement les circuits d'amplification à gain variable aussi appelés amplificateurs à gain variable (VGA de l'anglais "Variable Gain Amplifier").

<u>Technique antérieure</u>

Les circuits d'amplifications à gain variable destinés à amplifier des signaux radiofréquences avec un.gain commandé sont utilisés dans de nombreux circuits radiofréquences, par exemple dans des circuits radiofréquences prévus pour fonctionner dans le domaine des ondes millimétriques (mmW de l'anglais "millimeter Wave"), dans les bandes Ku ("Kurz- unten") ou Ka ("Kurz-above"), dans les bandes 4G, 5G, 6G, et dans d'autres bandes radiofréquences

Les déphaseurs permettant d'appliquer un déphasage commandable allant de 0° à 360° à un signal radiofréquence sont, par exemple, utilisés dans le domaine de la formation de faisceaux ("beamforming" en anglais). La formation de faisceaux est implémentée dans de nombreuses applications, par exemple dans le domaine des communications satellites LEO ou GEO, ou dans le domaine de la 5G ou de la 6G.

Les déphaseurs RTPS (de l'anglais "Reflection Type Phase Shifter") sont des déphaseurs passifs connus. Toutefois un inconvénient de ces déphaseurs connus est qu'ils sont encombrants et qu'ils sont configurés pour fonctionner à une fréquence cible, et n'ont donc pas une réponse stable lorsque les signaux à déphaser appartiennent à une bande de fréquences.

Un autre type de déphaseurs connus sont basés sur un générateur (ou modulateur) de signaux I/Q en phase et en quadrature, et deux amplificateurs à gain variables permettant une amplification commandée de chacun des signaux I et Q.

Bien que ces déphaseurs basés sur des amplifications à gain variable ne souffre pas des inconvénients indiqués ci-dessus pour les déphaseurs RTPS, ces déphaseurs basés sur des amplification à gain variable présentent d'autres inconvénients, certains de ces inconvénients résultants directement d'inconvénients des amplificateurs à gain variables connus utilisés dans ces déphaseurs.

<u>Résumé de l'invention</u>

Il existe un besoin de pallier tout ou partie des inconvénients des circuits amplificateurs à gain variable connus.

Un mode de réalisation pallie tout ou partie des inconvénients des circuits amplificateurs à gain variable connus.

Un mode de réalisation prévoit un dispositif d'amplification à gain variable configuré pour mettre en œuvre une segmentation d'une commutation en courant en au moins deux parties.

Un autre mode de réalisation prévoit un procédé d'amplification à gain variable dans lequel une commutation en courant dans un dispositif d'amplification à gain variable est segmentée en au moins deux parties.

Selon un mode de réalisation, le dispositif met en œuvre une segmentation d'un gain de transconductance en au moins deux parties.

Selon un mode de réalisation :

le dispositif comprend une cellule de Gilbert,

la cellule de Gilbert comprend un étage de transconductance, un étage de commutation en courant, et un étage de charge,

l'étage de commutation en courant est connecté entre l'étage de transconductance et l'étage de charge, et

la segmentation de la commutation en courant en au moins deux parties est mise en œuvre dans l'étage de commutation en courant.

Selon un mode de réalisation :

le dispositif est configuré pour recevoir un signal de commande sur N bits, avec N entier positif supérieur ou égal à 4,

une première desdites au moins deux parties de la segmentation de la commutation en courant est configurée pour être commandée par n1 bits du signal de commande, et

une deuxième desdites au moins deux parties de la segmentation de la commutation en courant est configurée pour être commandée par n1 bits du signal de commande, avec n1 et n2 des entiers positifs non nuls et N = n1 + n2.

Selon un mode de réalisation, la commutation en courant est mise en œuvre au moins en partie par des transistors bipolaires, de préférence des transistors BiMOS.

Selon un mode de réalisation :

le dispositif comprend une cellule de Gilbert,
la cellule de Gilbert comprend un étage de transconductance, un étage de commutation en courant, et un étage de charge,
l'étage de commutation en courant est connecté entre l'étage de transconductance et l'étage de charge,
la segmentation de la commutation en courant en au moins deux parties est mise en œuvre dans l'étage de commutation en courant, et
la segmentation du gain de transconductance en au moins deux parties est mise en œuvre dans l'étage de transconductance.

Selon un mode de réalisation :

le dispositif est configuré pour recevoir un signal de commande sur N bits, avec N entier positif supérieur ou égal à 4
une première desdites au moins deux parties de la segmentation de la commutation en courant est configurée pour être commandée par n1 bits du signal de commande,
une deuxième desdites au moins deux parties de la segmentation de la commutation en courant est configurée pour être commandée par n2 bits du signal de commande,
avec n1 et n2 des entiers positifs non nuls et N = n1 + n2, une première desdites au moins deux parties de la segmentation du gain de transconductance est configurée pour mettre en œuvre un gain de transconductance égal à gm1, et
une deuxième desdites au moins deux parties de la segmentation du gain de transconductance est configurée pour mettre en œuvre un gain de transconductance égal à $gm1/(2^{N-n2})$.

Selon un mode de réalisation, la commutation en courant est mise en œuvre au moins en partie par des transistors bipolaires, de préférence des transistors BiMOS, et le gain en transconductance est mis en œuvre au moins en partie par des transistors bipolaires, de préférence des transistors BiMOS.

Selon un mode de réalisation, au moins une desdites au moins deux parties de la segmentation de la commutation en courant est mise en œuvre de manière continue.

Selon un mode de réalisation, l'au moins une desdites au moins deux parties de la segmentation de la commutation en courant mise en œuvre de manière continue comprend un convertisseur numérique-analogique.

Selon un mode de réalisation, au moins une desdites au moins deux parties de la segmentation de la commutation courant est mise en œuvre de manière discrète.

Un autre mode de réalisation prévoit un dispositif de déphasage comprenant au moins un dispositif tel que défini ci-dessus.

Selon un mode de réalisation, le dispositif de déphasage :

un premier dispositif tel que défini ci-dessus, configuré pour appliquer un premier gain à un premier signal ; et
un deuxième dispositif tel que défini ci-dessus, configuré pour appliquer un deuxième gain à un deuxième signal en quadrature avec le premier signal, les premier et deuxième gains déterminant une valeur de déphasage, et le dispositif de déphasage comprenant, par exemple, un modulateur I/Q configuré pour fournir les premier et deuxième signaux.

Un autre mode de réalisation prévoir un dispositif d'émission ou de réception d'un faisceau mis en forme, comprenant plusieurs dispositifs de déphasage tels que définis ci-dessus.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente, de manière schématique et sous la forme de blocs, un mode de réalisation d'un amplificateur à gain variable ;
la figure 2 illustre, par un circuit, le fonctionnement d'un circuit de l'amplificateur de la figure 1 ;
la figure 3 représente un exemple d'un mode de réalisation d'un circuit de l'amplificateur de la figure 1 ;
la figure 4 représente un exemple d'un mode de réalisation d'un autre circuit de l'amplificateur de la figure 1 ;
la figure 5 représente un exemple d'un autre mode de réalisation du circuit de la figure 4 ;

la figure 6 représente un exemple d'un autre mode de réalisation d'un amplificateur à gain variable ;

la figure 7 représente un exemple d'un mode de réalisation d'un déphaseur comprenant deux amplificateurs à gain variable ;

la figure 8 représente un exemple d'un mode de réalisation d'un circuit émetteur d'un faisceau mis en forme ; et

la figure 9 représente un exemple d'un mode de réalisation d'un circuit récepteur d'un faisceau mis en forme.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais « coupled ») entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes « avant », « arrière », « haut », « bas », « gauche », « droite », etc., ou relative, tels que les termes « dessus », « dessous », « supérieur », « inférieur », etc., ou à des qualificatifs d'orientation, tels que les termes « horizontal », « vertical », etc., il est fait référence, sauf précision contraire, à l'orientation des figures.

Sauf précision contraire, les expressions « environ », « approximativement », « sensiblement », et « de l'ordre de » signifient à 10 % ou à 10° près, de préférence à 5 % ou à 5° près.

Il est ici proposé un amplificateur à gain variable dans lequel est mise en œuvre une segmentation, ou séparation en au moins deux parties, d'une commutation en courant ("current switching" en anglais), c'est à dire une segmentation, ou séparation en au moins deux partie, d'un aiguillage du courant.

Comme cela sera décrit plus en détails par la suite, lorsque les différentes parties de la segmentation en courant sont mises chacune en œuvre de manière discrète, il est également proposé une segmentation, ou séparation en au moins deux parties, d'un gain de transconductance. De préférence, dans ce cas, le nombre de parties de la segmentation en courant est égal au nombre de parties de la segmentation du gain.

Comme cela sera décrit plus en détails par la suite, lorsque les différentes parties de la segmentation en courant sont mises chacune en œuvre de manière continue, il est également proposé une segmentation, ou séparation en au moins deux parties, d'un gain de transconductance. De préférence, dans ce cas, le nombre de parties de la segmentation en courant est égal au nombre de parties de la segmentation du gain.

Comme cela sera décrit plus en détails par la suite, lorsqu'une ou plusieurs parties de la segmentation en courant sont mises chacune de manière discrète et qu'une ou plusieurs autres parties de la segmentation en courant sont mises en œuvre chacune de manière continue, il pourra être prévu soit de segmenter le gain en transconductance, soit que la segmentation du gain en transconductance soit omise.

En pratique, segmenter la commutation en courant revient à segmenter le contrôle du gain variable de l'amplificateur.

Par ailleurs, l'amplificateur à gain variable proposé ici comprend une cellule (ou mélangeur - "mixer" en anglais) de Gilbert. La cellule comprend un étage de transconductance ("transconductance stage" en anglais), un étage de commutation en courant ("current switching stage" en anglais) dans lequel est mise en œuvre la segmentation de la commutation en courant, et un étage de charge ("load stage" en anglais). L'étage de commutation en courant est segmenté en plusieurs parties et est connecté entre l'étage de tranconductance et l'étage de charge. De préférence, lorsque le gain en transconductance est également segmenté, chaque partie de la segmentation en courant est connectée entre une partie correspondante de la segmentation du gain, et l'étage de charge. Lorsque le gain en transconductance est segmenté, cette segmentation est mise en œuvre dans l'étage de transconductance. A titre d'exemple, de manière usuelle, la cellule de Gilbert comprend un circuit de polarisation de l'étage de transconductance.

La prévision d'une segmentation de la commutation en courant dans un amplificateur à gain variable permet de réduire le nombre de composant utilisé dans le chemin RF, et donc de réduire la capacité de sortie de l'amplificateur à gain variable, ou, dit autrement, d'augmenter l'impédance de sortie de l'amplificateur. Cette augmentation de l'impédance de sortie est faite sans réduire le gain et la précision sur le contrôle du gain.

A titre d'exemple, l'augmentation de l'impédance de sortie de l'amplificateur est avantageuse dans les circuits radiofréquences (RF) bidirectionnels avants ("bidirectional RF front-ends circuits" en anglais), car elle permet d'éviter la chute de gain résultant des impédances faibles des amplificateurs à gain variable connus.

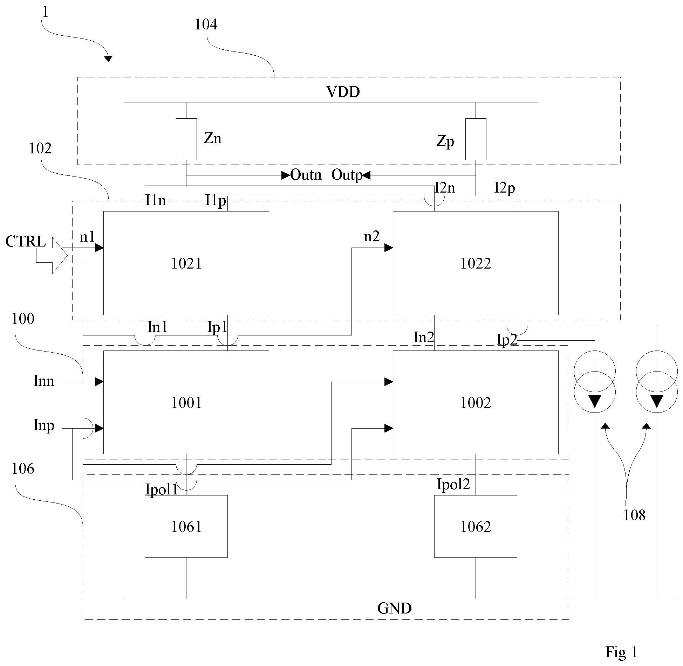

La figure 1 représente, de manière schématique et sous la forme de blocs, un mode de réalisation d'un amplificateur à gain variable 1, dans lequel est mis en œuvre une segmentation de la commutation en courant en M parties 102j, avec j un indice entier allant de 1 à M, et M un entier positif supérieur ou égal à 2. L'amplificateur 1 permet de mettre en œuvre une amplification à gain variable où la commutation en courant effectuée dans l'amplificateur 1 est segmentée en M parties.

Dans l'exemple de la figure 1, M est égal à 2 et la commutation en courant est segmentée en deux parties 1021 et 1022.

En outre, dans le mode de réalisation de la figure 1, le gain en transconductance est lui aussi segmenté en plusieurs parties. Plus particulièrement, dans l'exemple de la figure 1, le gain en transconductance est lui aussi segmenté en M parties 100j (1001 et 1002 en figure 1).

Le dispositif 1 d'amplification à gain variable comprend une cellule de Gilbert comprenant un étage de transconductance 100, un étage de commutation en courant 102 et un étage de charge 104. L'étage de commutation en courant 102 est connecté entre l'étage de transconductance 100 et l"étage de charge 104. En outre, de manière usuelle dans une cellule de Gilbert, l'amplificateur 1 comprend un circuit de polarisation 106 de l'étage de transconductance 100.

L'étage de transconductance 100 est configuré pour recevoir les deux composantes Inp et Inn d'un signal (tension) différentiel à amplifier. L'étage 100 est configuré pour fournir, à chaque partie 102j de la segmentation de la commutation en courant mise en œuvre dans l'étage 102, deux courants résultant d'un produit d'une valeur de transconductance par, respectivement, les deux composantes Inp et Inn du signal à amplifier.

Dans ce mode de réalisation où le gain en transconductance est segmenté en M parties 100j, chaque partie 100j reçoit les deux composantes Inn et Inp du signal différentiel à amplifier. En outre, chaque partie 100j est configurée pour fournir deux courants Inj et Ipj résultant d'un produit d'une valeur de transconductance par, respectivement, les deux composantes Inp et Inn du signal à amplifier. De préférence, la valeur de transconductance gmj est différente pour chaque partie 100j de la segmentation du gain en transconductance.

Dans l'exemple de la figure 1, la partie 1001 fournit un courant In1 résultant du produit d'une transconductance gm1 par la composante Inn, et un courant Ip1 résultant du produit de la transconductance gm1 par la composante Inp. En outre, dans l'exemple de la figure 1, la partie 1002 fournit un courant In2 résultant du produit d'une transconductance gm2 par la composante Inn, et un courant Ip2 résultant du produit de la transconductance gm2 par la composante Inp.

Dans l'exemple de la figure 1, de préférence, la transconductance gm2 est égale à $gm1/(2^{N-n1})$, c'est à dire à $gm1/2^{n2}$.

De préférence, sur les sorties de chaque partie 100j de la segmentation du gain en transconductance qui ne correspond pas à la plus forte valeur gmj de transconductance, il est prévu un circuit de compensation continu (DC - de l'anglais "Direct Current"). Pour chaque partie 100j de la segmentation en transconductance qui ne correspond pas à la plus forte valeur de transconductance, la compensation DC a, par exemple, pour but d'ajouter deux courants continus aux deux courants Inj et Ipj fournis par cette partie 100j de la segmentation, de sorte à compenser la différence entre l'amplification de mode commun par cette partie de la segmentation en transconductance et l'amplification de mode commun de la partie de la segmentation en courant correspondant à la plus forte valeur de transconductance gmj.

Par exemple, dans l'exemple de la figure, il est considéré que gm2 est inférieur à gm1, et un circuit de compensation DC 108 est prévu sur les sorties de la partie 1002 de l'étage 100.

L'étage de polarisation 106 est configuré pour polariser l'étage 100, c'est à dire pour fournir au moins un courant de polarisation l'étage de transconductance 100. Dans l'exemple de la figure 1, l'étage 106 est configuré pour fournir un courant de polarisation Ipolj (Ipol1 et Ipol2 en figure 1) à chaque partie 100j de l'étage 100.

Par exemple, l'étage 106 comprend une unique source de courant fournissant un courant de polarisation Ipol se répartissant sous la forme de courants Ipolj entre les parties 100j de l'étage 100. A titre d'autre exemple, comme cela est illustré en figure 1, l'étage 106 comprend autant de source de courant 106j qu'il y a de parties 100j dans l'étage de transconductance 100. Par exemple, en figure 1, l'étage 106 comprend une source de courant 1061 configurée pour fournir le courant de polarisation Ipol1 à la partie 1001 de l'étage 100, et une source de courant 1062 configurée pour fournir le courant de polarisation Ipol2 à la partie 1002 de l'étage 100.

L'étage 106 est connecté entre l'étage 100 et un premier potentiel d'alimentation, par exemple un potentiel d'alimentation bas, ou potentiel de référence, par exemple la masse GND.

A titre d'exemple, chaque source de courant 106j de l'étage 106 est connectée entre l'étage 100 et le potentiel GND, par exemple entre une partie 100j correspondante de l'étage 100 et le potentiel GND.

A titre d'exemple, lorsque le gain en transconductance est segmenté comme c'est le cas dans le mode de réalisation illustré par la figure 1, et que l'étage 100 comprend plusieurs parties 100j ayant chacune une valeur de transconductance gmj différente, la valeur de transconductance gmj de cette partie 100i de l'étage 100 peut être déterminée par les dimensions des transistors utilisés pour mettre en œuvre cette partie 100j de l'étage 100, et/ou par la valeur du courant de polarisation Ipolj reçu de l'étage 106 par cette partie 100j de l'étage 100.

Chaque partie 102j de la segmentation de la commutation en courant, ou, dit autrement, chaque partie 102j de l'étage 102, est configurée pour recevoir une partie correspondante des N bits d'un signal de commande CTRL reçu par l'étage 102, avec N entier strictement positif supérieur ou égal à 2, par exemple supérieur ou égal à 4. Dit autrement, chaque partie 102i est configurée pour recevoir nj bits parmi les N bits, de préférence nj bits ayant des poids successifs et étant différents des nj bits reçus par chaque autre partie 102j de l'étage 100. La somme des nj bits reçus par les parties 102j est égale à N.

Par exemple, en figure 1, la partie 1021 reçoit n1 bits parmi les N bits du signal CTRL, et la partie 1022 reçoit n2 autres bits parmi les N bits du signal CTRL, avec N = n1 + n2. n1 et n2 sont chacun des entiers strictement positifs.

Chaque partie 102j de l'étage 102 est configurée pour séparer le courant Inj qu'elle reçoit en deux portions, la première portion du courant Inj étant fournie à une sortie Outn du dispositif 1, la deuxième portion de ce courant Inj étant fournie à une sortie Outp du dispositif 1. Le ratio entre les première et deuxième portions du courant Inj est déterminé par l'état nj des bits de commande. De manière symétrique, chaque partie 102j de l'étage 102 est configurée pour séparer le courant Ipj courant qu'elle reçoit en deux portions, la première portion de ce courant Ipj étant fournie à la sortie Outn du dispositif 1, la deuxième portion de ce courant Ipj étant fournie à la sortie Outp du dispositif 1. Le ratio entre les première et deuxième portions du courant Ipj est déterminé par l'état des nj bits de commande. La somme des premières portions des courants Inj et Inpj qui est fournie à la sortie Outn du dispositif est référencée Ijn, et la somme des premières portions des courants Inj et Inpj qui est fournie à la sortie Outn du dispositif est référencée Ijp.

A titre d'exemple, en figure 1, la partie 1021 de l'étage 102 fournit à la sortie Outn un courant I1n correspondant à la somme de la première portion du courant In1 et de la première portion du courant Ip1, et fournit à la sortie Outp un courant I1p correspondant à la somme de la deuxième portion courant In1 et de la deuxième portion du courant Ip1. Les valeurs des courants I1n et I1p sont déterminées par les courants In1 et Ip1 et par les n1 bits de commande reçus par la partie 1021. De manière similaire, en figure 1, la partie 1022 de l'étage 102 fournit à la sortie Outn un courant I2n correspondant à la somme de la première portion du courant In2 et de la première portion du courant Ip2, et fournit à la sortie Outp un courant I2p correspondant à la somme de la deuxième portion courant In2 et de la deuxième portion du courant Ip2. Les valeurs des courants I2n et I2p sont déterminées par les courants In2 et Ip2 et par les n2 bits de commande reçus par la partie 1022.

L'étage de charge 104 est connecté entre les sorties Outn et Outp, et un potentiel d'alimentation, par exemple un potentiel d'alimentation haut VDD. Dit autrement, l'étage 104 est connecté entre l'étage 102 et le potentiel VDD.

L'étage 104 est configuré pour convertir la somme des courants Ijn (I1n et I2n en figure 1) fournis à la sortie Outn par l'étage 102 en une tension disponible sur la sortie Outn, et la somme des courants Ijp (I1p et I2p en figure 1) fournis à la sortie Outp par l'étage 102 en une tension disponible sur la sortie Outp. Par exemple, l'étage de charge 104 comprend une impédance Zn connectée entre la sortie Outn et le potentiel VDD, et une impédance Zp connectée entre la sortie Outp et le potentiel VDD, l'impédance Zp étant identique à l'impédance Zn.

Les tensions disponibles sur les deux sorties Outn et Outp du dispositif 1 correspondent aux deux composantes d'un signal différentiel de sortie du dispositif 1, cette tension de sortie correspondant à la tension différentielle d'entrée Inn, Inp amplifiée par un gain dont la valeur est commandée par les N bits du signal CTRL.

De préférence, dans le mode de réalisation de la figure 1 où le gain en transconductance est segmenté, le poids des nj bits commandant chaque partie 102j de l'étage 102 augmente avec la valeur de transconductance gmj de la partie 100j de l'étage 100 fournissant les deux courants Inj et Ipj à cette partie 102j de l'étage 102.

Dans l'exemple de la figure 1 où la partie 1021 reçoit des courants In1 et Ip1 de la partie 1001 correspondant à une transconductance de valeur gm1, et la partie 1022 reçoit des courants In2 et Ip2 de la partie 1002 correspondant à une transconductance de valeur gm2 inférieure à la valeur gm1, les n1 bits du signal CTRL ont des poids plus forts que les n2 bits du signal CTRL, ou, dit autrement, les n1 bits sont les bits de poids forts du signal CTRL et les n2 bits sont les bits de poids faibles du signal CTRL.

De préférence, dans le dispositif 1, les commutations (ou aiguillages) en courant commandées par le signal CTRL sont mises en œuvre par des transistors bipolaires qui permettent des gains plus élevés à surface équivalente que de transistors MOS, bien qu'une mise en œuvre avec des transistors MOS soit envisageable. Par ailleurs, lorsque les commutations en courant sont mises en œuvre par des transistors bipolaires, ces derniers sont de préférence des transistors BiCMOS qui sont à plus faibles bruits que des transistors bipolaires classiques.

De manière similaire, l'étage de transconductance est de préférence mis en œuvre par des transistors bipolaires qui permettent des gains plus élevés à surface équivalente que de transistors MOS, bien qu'une mise en œuvre avec des transistors MOS soit envisageable. Lorsque l'étage de transconductance est mis en œuvre par des transistors bipolaires, ces derniers sont de préférence des transistors BiCMOS qui sont à plus faibles bruits que des transistors bipolaires classiques.

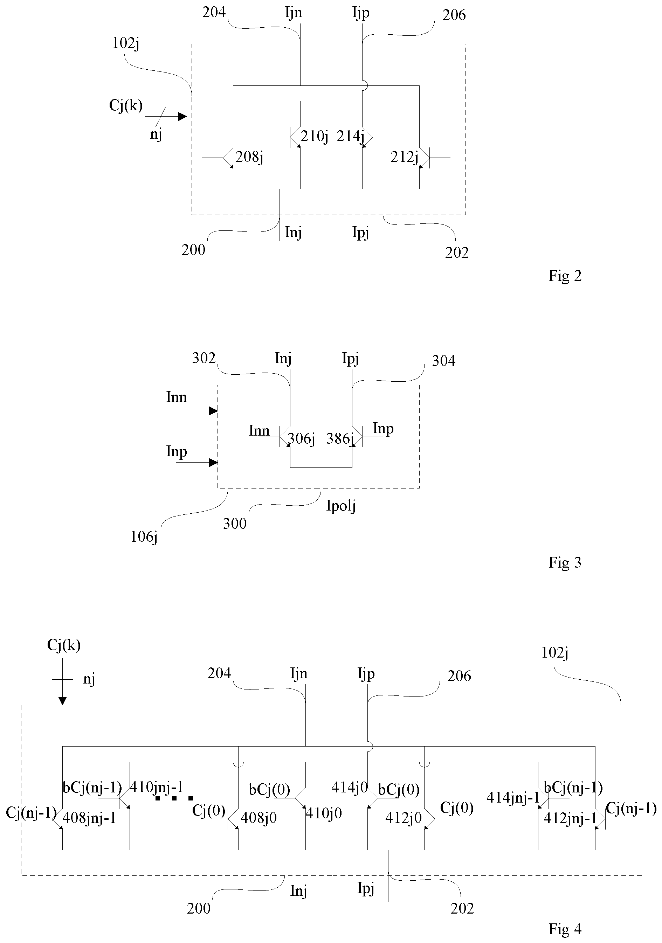

La figure 2 illustre, par un circuit, le fonctionnement d'un circuit correspondant à une partie 102j de la segmentation en courant de l'amplificateur 1 de la figure 1.

La partie 102j comprend une entrée 200 configurée pour recevoir le courant Inj, et une entrée 202 configurée pour recevoir le courant Ipj. La partie 102j comprend une sortie 204 configurée pour fournir le courant Ijn et une sortie configurée pour fournir le courant Ijp.

La partie 102j reçoit nj bits de commande Cj(k), avec k un indice entier allant de 0 à nj-1.

Les nj bits Cj(k) commandent un ou plusieurs transistors connectés en parallèle entre l'entrée 200 et la sortie 204, ces transistors étant représentés par un unique transistor 208j en figure 2, et un ou plusieurs transistors connectés en parallèle entre l'entrée 200 et la sortie 206, ces transistors étant représentés par un unique transistor 210j en figure 2.

Les transistors 208j et 210j forment une première paire différentielle commandée par les nj bits Cj(k). Les transistors 208j et 210j sont commandés de manière complémentaire. Par exemple, le transistor 208j est commandé par les bits Cj(k), et le transistor 210j est commandé par des bits bCj(k), chaque bit bCj (k) étant le complément binaire du bit Cj(k) de même indice k.

De manière symétrique, les nj bits Cj(k) commandent un ou plusieurs transistors connectés en parallèle entre l'entrée 202 et la sortie 204, ces transistors étant représentés par un unique transistor 212j en figure 2, et un ou plusieurs transistors connectés en parallèle entre l'entrée 202 et la sortie 206, ces transistors étant représentés par un unique transistor 214j en figure 2.

Les transistors 212j et 214j forment une deuxième paire différentielle commandée par les nj bits Cj(k). Les transistors 212j et 214j sont commandés de manière complémentaire. Par exemple, le transistor 212j est commandé, comme le transistor 208j, par les bits Cj(k), et le transistor 214j est commandé, comme le transistor 210j, par les bits bCj(k).

Ainsi, en fonction de l'état des nj bits de commande, un pourcentage X du courant Inj est transmis vers la sortie 204, un pourcentage 100-X du courant Inj est transmis vers la sortie 206, un pourcentage X du courant Ipj est transmis vers la sortie 204, et un pourcentage 100-X du courant du Ipj est transmis vers la sortie 206.

On verra par la suite que chacun des transistors 208j, 210j, 212j et 214j peut être mis en œuvre par un seul transistor commandé par un signal continu déterminé par les nj bits Cj(k) (implémentation continue de la partie 102j), ou par plusieurs transistors en parallèle commandés par les nj bits Cj(k), par exemple nj transistors en parallèle commandés chacun par un bit Cj(k) d'indice différent (implémentation discrète).

La figure 3 illustre un exemple d'un mode de réalisation d'un circuit de l'amplificateur de la figure 1 correspondant à une partie 100j de la segmentation en transconductance de l'amplificateur 1 de la figure 1.

La partie 100j comprend une entrée 300 configurée pour recevoir le courant Ipolj, une sortie 302 configurée pour fournir le courant Inj, et une sortie 304 configurée pour fournir le courant Ipj.

Un transistor 306j est connecté entre l'entrée 300 et la sortie 302, et un transistor 308j est connecté entre l'entrée 300 et la sortie 304.

Les transistors 306j et 308j forment une paire différentielle commandée par les composantes Inp et Inn du signal d'entrée. Les transistors 306j et 308j sont commandés de manière complémentaire. Par exemple, le transistor 306j est commandé par la composante Inn du signal d'entrée, et le transistor 308j est la composante Inn du signal d'entrée.

La figure 4 représente un exemple d'un mode de réalisation d'un circuit correspondant à une partie 102j de la segmentation en courant de l'amplificateur 1 de la figure 1.

Plus particulièrement, dans ce mode de réalisation, les commutations en courant dans le circuit 102j sont mises en œuvre de manière discrète.

Le transistor 208j représenté en figure 2 correspond, dans ce mode de réalisation, à nj transistors 408jk en parallèle entre l'entrée 200 du circuit 102j et la sortie 204 du circuit 102j, avec k un indice allant de 0 à nj-1. Chaque transistor 408jk est commandé par le bit Cj(k) d'indice k correspondant, le poids des bits nj bits Cj(k) étant croissant avec l'indice k. En outre, chaque transistor 408jk a, par exemple, des dimensions 2 fois plus grandes que le transistors 408jk-1 d'indice k-1. Par exemple, le transistor 408j1 est deux fois plus gros que le transistor 408j0.

De manière similaire, le transistor 210j représenté en figure 2 correspond, dans ce mode de réalisation, à nj transistors 410jk en parallèle entre l'entrée 200 du circuit 102j et la sortie 206 du circuit 102j. Chaque transistor 410jk est commandé par le complément binaire bCj(k) du bit Cj(k) d'indice k correspondant. En outre, chaque transistor 410jk a, par exemple, des dimensions 2 fois plus grandes que le transistors 410jk-1 d'indice k-1, et, de préférence, les mêmes dimensions que le transistor 408jk de même indice k.

Le transistor 212j représenté en figure 2 correspond, dans ce mode de réalisation, à nj transistors 412jk en parallèle entre l'entrée 202 du circuit 102j et la sortie 204 du circuit 102j, avec k un indice allant de 0 à nj-1. Chaque transistor 412jk est commandé par le bit Cj(k) d'indice k correspondant. En outre, chaque transistor 412jk a, par exemple, des dimensions 2 fois plus grandes que le transistors 412jk-1 d'indice k-1, et, de préférence, les mêmes dimensions que le transistor 408jk de même indice k.

De manière similaire, le transistor 214j représenté en figure 2 correspond, dans ce mode de réalisation, à nj transistors 414jk en parallèle entre l'entrée 202 du circuit 102j et la sortie 206 du circuit 102j. Chaque transistor 414jk est commandé par le complément binaire bCj(k) du bit Cj(k) d'indice k correspondant. En outre, chaque transistor 414jk a, par exemple, des dimensions 2 fois plus grandes que le transistors 414jk-1 d'indice k-1, et les mêmes dimensions que le transistor 408jk de même indice k.

En figure 4, pour ne pas surcharger la figure, seuls les transistors 408j0, 408jnj-1, 410j0, 410jnj-1, 412j0, 412jnj-1, 414j0, 414jnj-1, et les bits Cj(0), Cj(nj-1), bCj(0) et bCj(nj-1) sont représentés.

A titre d'exemple, chacun des transistors 408jk, 410jk, 412jk, et 414jk est mis en œuvre par un ou plusieurs transistors bipolaires, de préférence un ou plusieurs transistors BiMOS.

Selon un mode de réalisation, lorsque plusieurs parties de la segmentation en courant sont mises en œuvre chacune de manière discrète par un circuit 102j correspondant tel que décrit en relation avec la figure 4, dans tous ces circuits 102j, les transistors 408j0 ont tous les mêmes dimensions. En reprenant l'exemple de la figure 1, dans le cas où chacun des circuits 1021 et 1022 est mis en œuvre de manière discrète comme cela est représenté en figure 4, alors le transistor 40810 a les mêmes dimensions que le transistor 40820. En outre, de préférence, comme cela a été indiqué ci-dessus à titre d'exemple, les transistors 40810, 40820, 41010, 41020, 41210, 41220, 41410 et 41420 ont tous les mêmes dimensions.

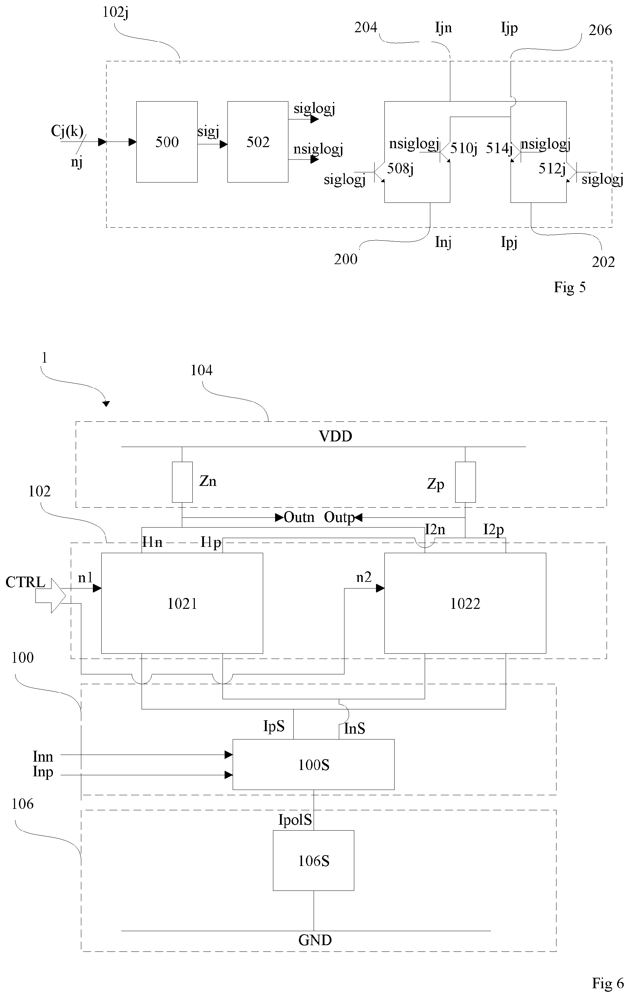

La figure 5 représente un exemple d'un mode de réalisation d'un circuit correspondant à une partie 102j de la segmentation en courant de l'amplificateur 1 de la figure 1.

Plus particulièrement, dans ce mode de réalisation, les commutations en courant dans le circuit 102j sont mises en œuvre de manière continue.

Le transistor 208j représenté en figure 2 correspond, dans ce mode de réalisation, à un transistor 508j connecté entre l'entrée 200 du circuit 102j et la sortie 204 du circuit 102j. Le transistor 508j est commandé par un signal analogique déterminé par les nj bits Cj(k).

De manière similaire, le transistor 210j représenté en figure 2 correspond, dans ce mode de réalisation, à un transistor 510j connecté entre l'entrée 200 du circuit 102j et la sortie 206 du circuit 102j. Le transistor 510j est commandé par un signal analogique déterminé par les nj bits bCj(k) correspondant aux compléments binaires des nj bits Cj(k). Le transistor 510j a, par exemple, les mêmes dimensions que le transistor 508j.

Le transistor 212j représenté en figure 2 correspond, dans ce mode de réalisation, à un transistor 512j connecté entre l'entrée 202 du circuit 102j et la sortie 204 du circuit 102j. Le transistor 512j est commandé par un signal analogique déterminé par les nj bits Cj(k). Le transistor 512j a, par exemple, les mêmes dimensions que le transistor 508j.

De manière similaire, le transistor 214j représenté en figure 2 correspond, dans ce mode de réalisation, à un transistor 514j connecté entre l'entrée 202 du circuit 102j et la sortie 206 du circuit 102j. Le transistor 514jk est commandé par un signal analogique déterminé par les nj bits bCj(k) correspondant aux compléments binaires des nj bits Cj(k). Le transistor 514j a, par exemple, les mêmes dimensions que le transistor 508j.

Dans ce mode de réalisation, le circuit 102j comprend en outre un convertisseur numérique analogique 500.

Le convertisseur 500 est configuré pour recevoir les nj bits Cj(k) et pour le convertir en un signal analogique sigj.

Le circuit 102j comprend en outre, dans cet exemple où les transistors 508j, 510j, 512j et 514j sont des transistors bipolaires, par exemple des transistors BiMOS, un circuit 502 de conversion linéaire vers logarithmique configuré pour recevoir le sigi et pour fournir deux signaux siglogj et nsiglogj complémentaires.

Les transistors 208j et 212j sont commandés par le signal siglogj et les transistors 510j et 514j sont commandés par le signal nsiglogj.

Bien que l'on ait décrit un circuit comprenant les deux circuits 500 et 502 configuré pour recevoir les nj bits Cj(k) et pour fournir les signaux analogiques de commande des transistors 508j, 510j, 512j et 514j dans le cas où il n'y a qu'un convertisseur 500, ce circuit peut comprendre deux convertisseur 500, par exemple un convertisseur 500 fournissant le signal sigj et un autre convertisseur 500 fournissant un signal nsigj complémentaire du signal sigj, ce signal nsigj correspondant à la conversion numérique analogique des nj bits bCj(k).

De préférence, les transistors 508j, 510j, 512j et 514j ont tous les mêmes dimensions.

A titre d'exemple, chacun des transistors 508j, 510j, 512j, et 514j est mis en œuvre par un ou plusieurs transistors bipolaires, de préférence un ou plusieurs transistors BiMOS.

Selon un mode de réalisation, lorsque plusieurs parties de la segmentation en courant sont mises en œuvre chacune de manière continue par un circuit 102j correspondant tel que décrit en relation avec la figure 5, dans tous ces circuits 102j, les transistors 508j de chaque deux étages 102j différents ont des dimensions configurées pour garder la même densité de courant dans ces deux étages 102j. Par exemple, pour chaque deux étages 102j, le rapport entre les dimensions du transistor 508j d'un premier des deux étages 102j et des dimensions du transistors 508j du deuxième des deux étages 102j suit le rapport binaire entre les nj bits de commande du premier des deux étages 102j et les nj bits de commande du deuxième des deux étages 102j. Par exemple, en reprenant l'exemple de la figure 1, dans le cas où chacun des circuits 1021 et 1022 est mis en œuvre de manière continue comme cela est représenté en figure 5, alors le rapport entre les dimensions du transistor 5080 et les dimensions du transistor 5081 suit le rapport binaire entre les n1 bits de commande de l'étage 1021 et les n2 bits de commande de l'étage 1022. En outre, de préférence, comme cela a été indiqué ci-dessus à titre d'exemple, les transistors 5081, 5101, 5121, et 5141 de l'étage 1021 ont tous les mêmes dimensions, et les transistors 5082, 5102, 5122, et 5142 de l'étage 1022 ont tous les mêmes dimensions.

Selon un mode de réalisation, toutes les parties 102j de la segmentation en courant, par exemple les deux parties 1021 et 1022 de l'exemple de la figure 1, sont mises en œuvre de manière continue, chacune par un circuit 102j tel que décrit en relation avec la figure 5.

Selon un mode de réalisation, lorsqu'au moins une partie de la segmentation en courant en mise en œuvre de manière discrète, et qu'au moins une autre partie de la segmentation en courant est mise en œuvre de manière continue, alors le transistor 508j de chaque circuit 102j mis en œuvre de continue (figure 5) a des dimensions déterminées par le rapport binaire entre son pas de courant et le pas de courant le plus petit des circuits 102j. Dit autrement, entre un premier étage 102j mis en œuvre de manière continue et un deuxième étage 102j mis en œuvre de manière discrète, le rapport des dimensions du transistor 408jk du premier étage 102j mis en œuvre de manière discrète et des dimension du transistor 508j du deuxième étage 102j mis en œuvre de manière continue est, par exemple, déterminé par le rapport binaire entre le bit de commande Cj(k) du transistor 408jk du premier étage 102j discret et nj les bits de commande Cj(k) du transistor 408j du deuxième étage 102j continu.

A titre d'exemple, en se référant de nouveau à la figure 1, le signal CTRL code une valeur numérique discrète Val comprise dans la plage allant de 0 à $2^N$-1, et donc la valeur est déterminée par l'état des N bits du signal CTRL comprenant n1 bits de poids forts et n2 bits de poids faibles.

Dans cet exemple, le gain, ou transconductance, gm du dispositif 1 est égale à la somme des gains, ou transconductance, gmeq1 et gmeq2, où gmeq1 est le gain, ou transconductance, équivalent des deux circuits 1001 et 1021, et gmeq2 est le gain, ou transconductance, équivalent des deux circuits 1002 et 1022. On a alors les équations suivantes :

[Math 1]

$$gmeq2 = gm2.\frac{(2^{n2}-1)-2*(val.mod(2^{n2}))}{(2^{n2}-1)}$$

avec mod() l'opérateur modulo, et :

[Math 2]

$$gmeq1 = gm1.\frac{(2^{n1}-1)-2*(val/2^{n1})}{(2^{n1}-1)}$$

Toujours dans cet exemple, la variation de transconductance gm1, notée $\Delta$gm1, et la variation de transconductance gm2, notée $\Delta$gm2, sont alors reliées par les équations suivantes :

[Math 3]

$$\Delta gm1 = 2^{n2}.\Delta gm2$$

[Math 4]

$$gm2 = gm1/l$$

avec l un entier non nul, et

[Math 5]

$$\Delta gm2 = \frac{gm1}{l}.\frac{2}{2^{n2}-1}$$

A titre d'exemple, pour avoir une transition douce, on a alors :

[Math 6]

$$\Delta gm1 = 2^{n2}.\frac{gm1}{l}.\frac{2}{2^{n2}-1} = gm1.\frac{2}{2^{n1}-1}$$

D'où il résulte que :

[Math 7]

$$l = 2^{n2} \cdot \frac{2^{n1} - 1}{2^{n2} - 1} = 2^{n2} \cdot \frac{2^{N-n2} - 1}{2^{n2} - 1}$$

On comprend que l est entier si n1 = n2 = N/2, N étant pair.

Toutefois, dans un cas général n2 peut être différent N/2 ou N peut être impair. Dans ce cas, des interrupteurs de réserve ("spare switch" en anglais), c'est à dire des transistors de réserve, peuvent être prévu dans l'un des circuit 102j, de préférence dans le circuit 1022, pour que l soit un entier. Ajouter ces transistors de réserve dans le circuit 1022 revient à ajouter :

- un transistor 4082S identique au transistor 40820, le transistor 4082S étant connecté entre l'entrée 200 et le potentiel VDD auquel est connecté l'étage de charge 104, et non pas entre l'entrée 200 et la sortie 204 comme c'est le cas du transistor 40820. En outre le transistor 4082S est commandé comme le transistor 40820 ;
- un transistor 4102S identique au transistor 41020, le transistor 4102S étant connecté entre l'entrée 200 et le potentiel VDD auquel est connecté l'étage de charge 104, et non pas entre l'entrée 200 et la sortie 206 comme c'est le cas du transistor 41020. En outre le transistor 4102S est commandé comme le transistor 41020 ;
- un transistor 4122S identique au transistor 41220, le transistor 4122S étant connecté entre l'entrée 202 et le potentiel VDD auquel est connecté l'étage de charge 104, et non pas entre l'entrée 202 et la sortie 204 comme c'est le cas du transistor 41220. En outre le transistor 4122S est commandé comme le transistor 41220 ; et
- un transistor 4142S identique au transistor 41420, le transistor 4122S étant connecté entre l'entrée 200 et le potentiel VDD auquel est connecté l'étage de charge 104, et non pas entre l'entrée 202 et la sortie 206 comme c'est le cas du transistor 41420. En outre le transistor 4142S est commandé comme le transistor 41420.

En faisant cela, l'équation [Math7] devient :

[Math 8]

$$l = 2^{n2} \cdot \frac{2^{n1} - 1}{2^{n2} - 1 + 1} = 2^{n1} - 1 = 2^{N-n2} - 1$$

A titre d'exemple, si N est égal à 6 et que n2 est égal à 3, en utilisant l'équation [Math 7] correspondant au cas sans interrupteur de réserve, on obtient 1 = 8, et en utilisant l'équation [Math 8] correspondant au cas avec interrupteurs de réserve, on obtient I = 7.

A titre d'autre exemple, si N est égal à 6 et que n2 est égal à 4, en utilisant l'équation [Math 7] correspondant au cas sans interrupteur de réserve, on obtient 1 = 16/5 qui n'est donc pas un entier, et en utilisant l'équation [Math 8] correspondant au cas avec interrupteurs de réserve, on obtient 1 = 3.

A titre d'autre exemple, si N est égal à 7 et que n2 est égal à 3, en utilisant l'équation [Math 8] correspondant au cas avec interrupteurs de réserve, on obtient 1 = 15.

En relation avec la figure 1, un mode de réalisation d'un amplificateur à gain variable 1 a été décrit dans lequel, non seulement la commutation en courant est segmentée en plusieurs parties (ou circuits) 102j, mais en outre le gain en transconductance est segmenté, par exemple en autant de parties (ou circuits) 100j qu'il y a de circuits 102j.

Dans d'autres modes de réalisation, le gain en courant peut ne pas être segmenté, en particulier lorsque l'amplificateur 1 comprend seulement deux parties 1021 et 1022 où l'une des parties 1021 et 1022 est mise en œuvre de manière discrète, et l'autre des parties 1021 et 1022 est mise en œuvre de manière continue.

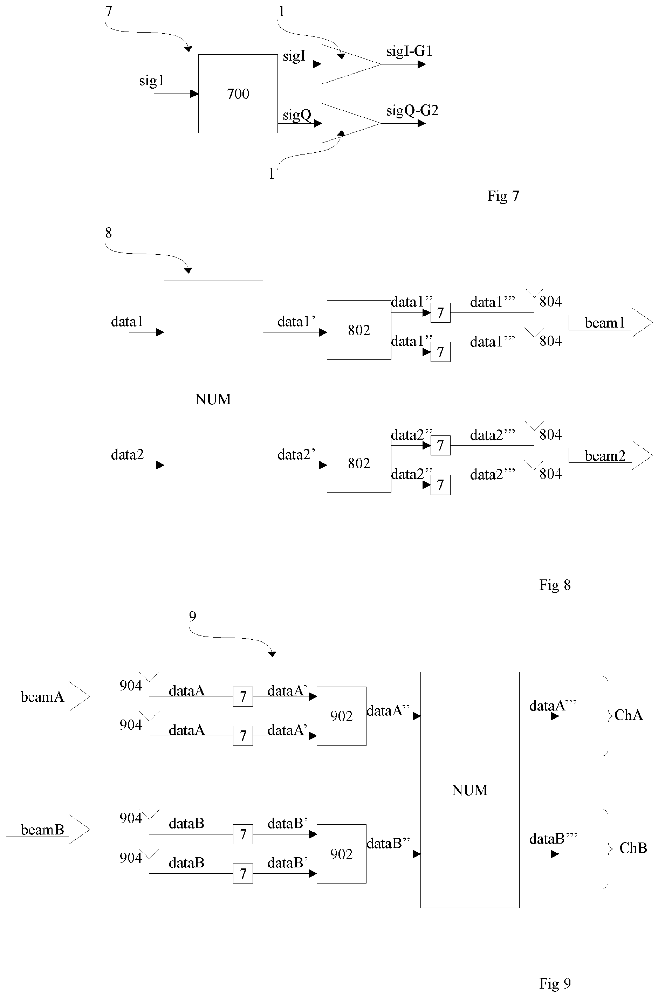

La figure 7 représente, de manière schématique et sous la forme de blocs, un mode de réalisation de l'amplificateur à gain variable 1 dans lequel la commutation en courant est segmentée, mais le gain en transconductance n'est pas segmenté. Dans ce mode de réalisation où le gain en transconductance n'est pas segmenté, au moins une des parties 102j est mise en œuvre de manière discrète, alors qu'au moins une autres des parties est mise en œuvre de manière continue. Plus particulièrement, dans l'exemple de la figure 7, l'étage de commutation en courant 102 est segmenté en M égal 2 parties 1021 et 1022. La partie 1021, respectivement 1022, est, à titre d'exemple, mise en œuvre de manière discrète, respectivement continue.

L'amplificateur 1 de la figure 7 comprend de nombreux élément en commun avec l'amplificateur 1 de la figure 1, et seules les différences entre ces deux amplificateurs 1 sont ici détaillées. Ainsi, sauf indication contraire, ce qui a été indiqué pour l'amplificateur de la figure 1 s'applique à l'amplificateur de la figure 7.

Par rapport à la figure 1, en figure 7 l'étage 100 de gain en transconductance est mis en œuvre par un seul circuit 106j tel que décrit en relation avec la figure 3, ce circuit étant référencé 106S en figure 6.

Il en résulte que l'étage de polarisation 106 ne comprend lui aussi qu'une seule source de courant, référencée 100S en figure 7, fournissant un courant de polarisation IpolS à l'étage 100, et, plus particulièrement au circuit 106S.

L'étage 100, c'est à dire le circuit 100S, fournit deux courants InS et IpS correspondant aux produits de la transconductance gm du circuit 100S par les composantes respectives Inn et Inp.

Ces courants InS et Ips sont distribués aux parties 102j de l'étage 102, ou, dit autrement, se répartissent entre les parties 102j de l'étage 102.

Selon un mode de réalisation, il est prévu un déphaseur, ou dispositif de déphasage, commandable comprenant au moins un amplificateur à gain variable 1, par exemple deux amplificateurs à gain variable 1.

La figure 7 représente un exemple de mode de réalisation d'un déphaseur 7 comprenant au moins un amplificateur à gain variable 1, et, plus particulièrement, deux amplificateurs 1.

Le dispositif 7 comprend un premier amplificateur 1 (en haut en figure 7) configuré pour appliquer un premier gain G1 à un premier signal sigI. Le signal résultant de cette amplification est un signal sigI-G1 de sortie du premier amplificateur 1.

Le dispositif 7 comprend un deuxième amplificateur 1 (en bas en figure 7) configuré pour appliquer un deuxième gain G2 à un deuxième signal sigQ en quadrature avec le signal sigI. Le signal résultant de cette amplification est un signal sigQ-G2 de sortie du deuxième amplificateur 1.

En recombinant les deux signaux sigI-G1 et sigQ-G2, par exemple en ajoutant les deux signaux sigI-G1 et sigQ-G2 l'un avec l'autre, on obtient un signal ayant une valeur de déphasage avec le signal sig1 qui est déterminé par les valeurs des gains G1 et G2 appliqués aux signaux respectifs sigI et sigQ par les deux amplificateurs 1.

A titre d'exemple, les deux signaux sigI et sigQ sont fournis par un modulateur I/Q 700. A titre d'exemple, le circuit 700 reçoit un signal sig1, et fournit le signal sigI en phase avec le signal sig1, et le signal sigQ en quadrature avec le signal sigI.

Selon un mode de réalisation, on prévoit un dispositif d'émission d'un faisceau mis en forme, ou un dispositif de réception d'un faisceau mis en forme comprenant plusieurs déphaseurs comprenant chacun au moins un amplificateur à gain variable 1, par exemple un dispositif d'émission ou de réception de faisceau mis en forme comprenant plusieurs déphaseurs 7.

La figure 8 représente un exemple d'un mode de réalisation d'un circuit 8 émetteur d'un faisceau mis en forme.

Le circuit ou dispositif 8 comprend un circuit de traitement numérique NUM configuré pour recevoir des données à émettre data1. Le circuit NUM est configurée pour mettre en forme, par exemple pour encoder, les données data1, et pour fournir un signal data1' correspondant à une chaîne d'émission radiofréquence 802.

La chaîne d'émission RF est configuré pour fournir, à partir du signal data1', une pluralité de signaux data1" à chacun desquels un déphasage différent va être appliqué. Par exemple, en figure 8, la chaine d'émission radiofréquence 802 fournit deux signaux data1".

Chaque signal data1" est fourni à un déphaseur 7 correspondant, chaque déphaseur 7 fournissant à une antenne 804 un signal data1‴. Plus particulièrement, chaque déphaseur 7 fournit un signal data1‴ correspondant au signal data1" reçu par ce déphaseur 7 auquel un déphasage de valeur commandée, par exemple par le circuit NUM, a été appliqué.

L'émission par les antennes 804 de la pluralité des signaux data1‴ résulte en l'émission d'un faisceau mis en forme beam1 correspondant.

Le chemin allant de la réception des données data1 par le circuit NUM jusqu'au faisceau mis en forme beam1 correspond à un premier canal d'émission Ch1.

A titre d'exemple, comme cela est illustré en figure 8, le dispositif 8 peut comprendre plus d'un canal. Par exemple, en figure 8, le dispositif 8 comprend un deuxième canal Ch2 comprenant la réception de données à transmettre data2 par le circuit NUM, la fourniture de données data2' correspondantes à une chaîne d'émission radiofréquence 802, la fourniture de plusieurs signaux correspondants data2'' par ce circuit 802 à des déphaseurs 7 correspondants, qui fournissent chacun à une antenne 804 correspondante un signal data2‴. L'émission par les antennes 804 des signaux data2‴ ayant des déphasages différents résulte en l'émission d'un faisceau mis en forme beam2.

La figure 9 représente un exemple d'un mode de réalisation d'un circuit 9 récepteur d'un faisceau mis en forme.

Un faisceau mis en forme beamA est reçu par une pluralité d'antenne 904, par exemple 2 antennes, du dispositif 9, chaque antenne fournissant un signal analogique dataA correspondant.

Chaque signal dataA est fourni à un déphaseur 7 correspondant, qui applique un déphasage de valeur commandée, par exemple par un circuit de commande numérique NUM. Chaque circuit 7 un signal dataA' correspondant au signal dataA qu'il a reçu auquel a été appliqué un déphasage de valeur commandée.

Les signaux analogiques dataA' sont fournis à une chaîne de réception radiofréquence 902, qui fournit, à partir de ces signaux dataA' reçus, un signal numérique dataA''.

Le signal dataA" est fourni à un circuit de traitement numérique NUM. Le circuit NUM est configurée pour décoder les signaux dataA'' de sorte à en extraire des données dataA''' qui ont été transmises au dispositif 9 via le faisceau mis en forme beamA.

Le chemin allant de la réception du faisceau mis en forme beamA par les antennes 904 jusqu'aux données numériques reçues dataA''' correspond à un premier canal de réception ChA.

A titre d'exemple, comme cela est illustré en figure 9, le dispositif 9 peut comprendre plus d'un canal. Par exemple, en figure 9, le dispositif 9 comprend un deuxième canal de réception ChB comprenant la réception, par des antennes 904, d'un faisceau mis en forme beamB, la fourniture, par ces antennes 904, de signaux analogiques dataB correspondants à des déphaseur 7 correspondants, qui fournissent chacun un signal dataB' déphasé d'une valeur commandable par rapport au signal dataB reçu, la fourniture des signaux analogiques dataB" à une chaîne de réception radiofréquence 902 qui fournit alors un signal numérique dataB" à partir de ces signaux dataB', et enfin l'extraction, à partir du signal dataB'' et par le circuit NUM, des données dataB''' reçues.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, bien que l'on ait décrit des exemples où M est égal à 2, la personne du métier sera en mesure de généraliser ces exemples à des cas où M est strictement supérieur à 2. Par exemple, pour M égal à 3, la personne du métier sera en mesure de mettre en œuvre une segmentation de la partie 1022 commandée par un signal de commande sur n2 bits deux nouvelles parties dont l'une est commandée par n21 bits de poids forts des n2 bits, et l'autre par n22 bits de poids faibles des n2 bits avec n2 = n21 + n22.

Enfin, la mise en œuvre pratique des modes de réalisation et variantes décrits est à la portée de la personne du métier à partir des indications fonctionnelles données ci-dessus.

**Revendications**

1. Dispositif d'amplification à gain variable (1) configuré pour mettre en œuvre une segmentation d'une commutation en courant (102) en au moins deux parties (1021, 1022).

2. Procédé d'amplification à gain variable dans lequel une commutation en courant (102) dans un dispositif d'amplification à gain variable (1) est segmentée en au moins deux parties (1021, 1022).

3. Dispositif selon la revendication 1, ou procédé selon la revendication 2, dans lequel le dispositif met en œuvre une segmentation d'un gain de transconductance (100) en au moins deux parties (1001, 1002).

4. Dispositif selon la revendication 1 ou 3, ou procédé selon la revendication 2 ou 3, dans lequel :

   le dispositif comprend une cellule de Gilbert,
   la cellule de Gilbert comprend un étage de transconductance (100), un étage de commutation en courant (102), et un étage de charge (104),
   l'étage de commutation en courant (102) est connecté entre l'étage de transconductance (100) et l'étage de charge (104), et
   la segmentation de la commutation en courant en au moins deux parties (1021, 1022) est mise en œuvre dans l'étage de commutation en courant (102).

5. Dispositif selon l'une quelconque des revendications 1, 3 et 4, ou procédé selon l'une quelconque des revendications 2 à 4, dans lequel :

   le dispositif (1) est configuré pour recevoir un signal de commande (CTRL) sur N bits, avec N entier positif supérieur ou égal à 4,
   une première (1021) desdites au moins deux parties de la segmentation de la commutation en courant est configurée pour être commandée par n1 bits du signal de commande, et
   une deuxième (1022) desdites au moins deux parties de la segmentation de la commutation en courant est configurée pour être commandée par n1 bits du signal de commande, avec n1 et n2 des entiers positifs non nuls et N = n1 + n2.

6. Dispositif selon l'une quelconque des revendications 1 et 3 à 5, ou procédé selon l'une quelconque des revendications 2 à 5, dans lequel la commutation en courant est mise en œuvre au moins en partie par des transistors bipolaires, de préférence des transistors BiMOS.

7. Dispositif selon la revendication 3, ou procédé selon la revendication 3, dans lequel :

   le dispositif comprend une cellule de Gilbert,

la cellule de Gilbert comprend un étage de transconductance (100), un étage de commutation en courant (102), et un étage de charge (104),

l'étage de commutation en courant (102) est connecté entre l'étage de transconductance (100) et l'étage de charge (104),

la segmentation de la commutation en courant en au moins deux parties (1021, 1022) est mise en œuvre dans l'étage de commutation en courant (102), et

la segmentation du gain de transconductance en au moins deux parties (1001, 1002) est mise en œuvre dans l'étage de transconductance.

8. Dispositif selon la revendication 3 ou 7, ou procédé selon la revendication 3 ou 7, dans lequel :

le dispositif est configuré pour recevoir un signal de commande sur N bits, avec N entier positif supérieur ou égal à 4

une première (1021) desdites au moins deux parties de la segmentation de la commutation en courant est configurée pour être commandée par n1 bits du signal de commande (CTRL),

une deuxième (1022) desdites au moins deux parties de la segmentation de la commutation en courant est configurée pour être commandée par n2 bits du signal de commande (CTRL), avec n1 et n2 des entiers positifs non nuls et N = n1 + n2,

une première (1001) desdites au moins deux parties de la segmentation du gain de transconductance (100) est configurée pour mettre en œuvre un gain de transconductance égal à gm1, et

une deuxième (1002) desdites au moins deux parties de la segmentation du gain de transconductance (100) est configurée pour mettre en œuvre un gain de transconductance égal à $gm1/(2^{N-n2})$.

9. Dispositif selon l'une quelconque des revendications 3, 7 et 8, ou procédé selon l'une quelconque des revendications 3, 7 et 8, dans lequel la commutation en courant (102) est mise en œuvre au moins en partie par des transistors bipolaires, de préférence des transistors BiMOS, et le gain en transconductance (100) est mis en œuvre au moins en partie par des transistors bipolaires, de préférence des transistors BiMOS.

10. Dispositif selon l'une quelconque des revendications 1 et 3 à 9, ou procédé selon l'une quelconque des revendications 2 à 9, dans lequel au moins une desdites au moins deux parties (1021, 1022) de la segmentation de la commutation en courant est mise en œuvre de manière continue.

11. Dispositif selon la revendication 10, ou procédé selon la revendication 10, dans lequel l'au moins une desdites au moins deux parties (1021, 1022) de la segmentation de la commutation en courant mise en œuvre de manière continue comprend un convertisseur numérique-analogique (500).

12. Dispositif selon l'une quelconque des revendications 1 et 3 à 9, ou procédé selon l'une quelconque des revendications 2 à 9, dans lequel au moins une desdites au moins deux parties (1021, 1022) de la segmentation de la commutation courant est mise en œuvre de manière discrète.

13. Dispositif de déphasage (7) comprenant au moins un dispositif (1) selon l'une quelconque des revendications 1 et 3 à 12.

14. Dispositif de déphasage (7) selon la revendication 13 comprenant :

un premier dispositif (1) selon l'une quelconque des revendications 1 et 3 à 12, configuré pour appliquer un premier gain à un premier signal (sigI) ; et

un deuxième dispositif (1) selon l'une quelconque des revendications 1 et 3 à 12, configuré pour appliquer un deuxième gain à un deuxième signal (sigQ) en quadrature avec le premier signal (sigI), les premier et deuxième gains déterminant une valeur de déphasage, et le dispositif de déphasage comprenant, par exemple, un modulateur I/Q (700) configuré pour fournir les premier et deuxième signaux.

15. Dispositif d'émission (8) ou de réception (9) d'un faisceau mis en forme, comprenant plusieurs dispositifs de déphasage (7) selon la revendication 13 ou 14.

1

104

VDD

Zn    Zp

102

Outn  Outp

Hn    Hp        I2n    I2p

CTRL    n1              n2

1021              1022

100

In1   Ip1        In2   Ip2

Inn

1001              1002

Inp

106

Ipol1           Ipol2

1061            1062

108

GND

Fig 1

Fig 2

Fig 3

Fig 4

Fig 5

Fig 6

7

sig1 → [700] → sigI → sigI-G1

1

sigQ → sigQ-G2

1'

Fig 7

8

data1 → [NUM] → data1' → [802] → data1'' → [7] → data1''' → 804 → beam1

data1'' → [7] → data1''' → 804

data2 → data2' → [802] → data2'' → [7] → data2''' → 804 → beam2

data2'' → [7] → data2''' → 804

Fig 8

9

beamA → 904 → dataA → [7] → dataA' → [902] → dataA'' → [NUM] → dataA''' → ChA

904 → dataA → [7] → dataA'

beamB → 904 → dataB → [7] → dataB' → [902] → dataB'' → dataB''' → ChB

904 → dataB → [7] → dataB'

Fig 9

**EP 4 757 175 A1**

Europäisches Patentamt
European Patent Office
Office européen des brevets

# RAPPORT DE RECHERCHE EUROPEENNE

Numéro de la demande

EP 25 31 5230

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2010/271128 A1 (AFSAHI ALI [US]) 28 octobre 2010 (2010-10-28) | 1-3, 10-12 | INV. H03F3/195 |
| A | * alinéa [0040]; figures 3,4 * | 4-9, 13-15 | H03F3/24 H03F3/45 H03G1/00 |
| | ----- | | |
| X | US 8 543 072 B1 (YAHAV NIR [IL]) 24 septembre 2013 (2013-09-24) | 1-3,5, 10-12 | |
| A | * figure 2 * | 4,6-9, 13-15 | |
| | ----- | | |
| X | US 2003/155959 A1 (BELOT DIDIER [FR] ET AL) 21 août 2003 (2003-08-21) | 1-4,6,7, 9-15 | |
| A | * figure 2A * | 5,8 | |
| A | US 2009/140809 A1 (CHI HOWARD H [US]) 4 juin 2009 (2009-06-04) * alinéas [0042] - [0044]; figure 5 * | 1-15 | |
| | ----- | | |
| A | US 5 736 899 A (BOWERS DEREK F [US] ET AL) 7 avril 1998 (1998-04-07) * colonne 2, ligne 57 - colonne 5, ligne 35; figure 4 * | 1-15 | DOMAINES TECHNIQUES RECHERCHES (IPC) |
| | ----- | | H03F H03G |

Le présent rapport a été établi pour toutes les revendications

| Lieu de la recherche | Date d'achèvement de la recherche | Examinateur |
|---|---|---|
| La Haye | 6 novembre 2025 | Goethals, Filip |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

......................................................................................
& : membre de la même famille, document correspondant

EPO FORM 1503 03.82 (P04C02)

18

## EP 4 757 175 A1

## ANNEXE AU RAPPORT DE RECHERCHE EUROPEENNE
## RELATIF A LA DEMANDE DE BREVET EUROPEEN NO.

EP 25 31 5230

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

06-11-2025

| Document brevet cité au rapport de recherche | Date de publication | Membre(s) de la famille de brevet(s) | Date de publication |
|---|---|---|---|
| US 2010271128 A1 | 28-10-2010 | AUCUN | |
| US 8543072 B1 | 24-09-2013 | US 8090334 B1<br>US 8543072 B1 | 03-01-2012<br>24-09-2013 |
| US 2003155959 A1 | 21-08-2003 | FR 2836305 A1<br>GB 2386271 A<br>US 2003155959 A1 | 22-08-2003<br>10-09-2003<br>21-08-2003 |
| US 2009140809 A1 | 04-06-2009 | AUCUN | |
| US 5736899 A | 07-04-1998 | AU 3290297 A<br>US 5736899 A<br>WO 9743825 A1 | 05-12-1997<br>07-04-1998<br>20-11-1997 |

EPO FORM P0460

Pour tout renseignement concernant cette annexe : voir Journal Officiel de l'Office européen des brevets, No.12/82